# EUROPEAN PATENT APPLICATION

(11) **EP 4 235 817 A1**
(43) Date of publication of application: **30.08.2023**
(21) Application number: 22202477.0
(22) Date of filing: 19.10.2022
(51) Int. Cl.: H01L 31/0687, H01L 31/078, H01L 31/0304, H01L 31/054, H01L 31/18

(54) **MULTIJUNCTION METAMORPHIC SOLAR CELLS**

(30) Priority: 28.02.2022 US 202217682171
(71) Applicant: SolAero Technologies Corp., a corporation of the state of Delaware, Albuquerque, NM 87123 (US)
(72) Inventor: DERKACS, Daniel, ALBUQUERQUE, 87111 (US); BITTNER, Zachary, ALBUQUERQUE, 87102 (US); HART, John, ALBUQUERQUE, 87106 (US)
(74) Representative: de Rooij, Mathieu Julien

(57) **Abstract**

Multijunction solar cells comprising: a growth substrate, a first solar subcell disposed over or in the growth substrate; a tunnel diode disposed over the first solar subcell; a graded interlayer directly disposed over the tunnel diode; a sequence of layers of semiconductor material disposed over the graded interlayer comprising one or more middle solar subcells including a second solar subcell disposed over and lattice mismatched with respect to the growth substrate; an upper subcell disposed over the middle solar subcells of a semiconductor compound including at least aluminum, indium, and phosphorus and a band gap in the range of 1.95 eV to 2.20 eV; wherein either the upper solar subcell, or the middle solar subcell directly below the upper solar subcell, or both, has an aluminum content in excess of 17.5% by mole fraction, but less than 25%.

## Description

### Field of the Invention

The present disclosure relates to multijunction solar cells and the fabrication of such solar cells, and more particularly the design and specification of the band gaps in multijunction solar cells based on III-V semiconductor compounds to provide greatest efficiency in orbit in a radiation environment or in a space vehicle over an operational lifetime from five to fifteen years.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to manufacture. Typical commercial III-V compound semiconductor multijunction solar cells have energy efficiencies that exceed 27% under one sun, air mass 0 (AM0), illumination, whereas even the most efficient silicon technologies generally reach only about 18% efficiency under comparable conditions. Under high solar concentration (e.g., 500X), commercially available III-V compound semiconductor multijunction solar cells in terrestrial applications (at AM1.5D) have energy efficiencies that exceed 37%. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as payloads become more sophisticated, and applications anticipated for five, ten, twenty or more years, the power-to-weight ratio and lifetime efficiency of a solar cell becomes increasingly more important, and there is increasing interest in not only the amount of power provided at initial deployment, but over the entire service life of the satellite system, or in terms of a design specification, the amount of power provided at a specific future time, often referred to as the "end of life" (EOL).

The efficiency of energy conversion, which converts solar energy (or photons) to electrical energy, depends on various factors such as the design of solar cell structures, the choice of semiconductor materials, and the thickness of each subcell. In short, the energy conversion efficiency for each solar cell is dependent on the optimum utilization of the available sunlight across the solar spectrum as well as the "age" of the solar cell, i.e. the length of time it has been deployed and subject to degradation associated with the temperature and radiation in the deployed space environment. As such, the characteristic of sunlight absorption in semiconductor material, also known as photovoltaic properties, is critical to determine the most efficient semiconductor to achieve the optimum energy conversion to meet customer requirements of intended orbit and lifetime.

Typical III-V compound semiconductor solar cells are fabricated on a semiconductor wafer in vertical, multijunction structures or stacked sequence of solar subcells, each subcell formed with appropriate semiconductor layers and including a p-n photoactive junction. Each subcell is designed to convert photons over different spectral or wavelength bands to electrical current. After the sunlight impinges on the front of the solar cell, and photons pass through the subcells, the photons in a wavelength band that are not absorbed and converted to electrical energy in the region of one subcell propagate to the next subcell, where such photons are intended to be captured and converted to electrical energy, assuming the downstream subcell is designed for the photon's particular wavelength or energy band.

The individual solar cells or wafers are then disposed in horizontal arrays, with the individual solar cells connected together in an electrical series and/or parallel circuit. The shape and structure of an array, as well as the number of cells it contains, are determined in part by the desired output voltage and current.

The electrical characteristics of a solar cell, such as the short circuit current (Jsc), the open circuit voltage (Voc), and the fill factor (FF), are affected by such factors as the number of subcells, the thickness of each subcell, the composition and doping of each active layer in a subcell, and the consequential band structure, electron energy levels, conduction, and absorption of each subcell, as well as its exposure to radiation in the ambient environment over time. The overall power output and conversion efficiency of the solar cell are thereby affected in different and often unpredictable ways. Such factors also vary over time (i.e. during the operational life of the system).

The designation and specification of such material parameters is a non-trivial engineering undertaking, and would vary depending upon the specific space mission and customer design requirements. Such design variables are interdependent and interact in complex and often unpredictable ways. Accordingly, it is evident that the consideration of any one material design parameter or variable, such as the amount of a particular constituent element in a layer, and therefore the resulting band gap of that layer, affects each of the electrical characteristics Jsc, Voc and FF in a different way, sometimes in opposite directions. Thus, such changes do not predictably lead to an increase in power output or solar cell efficiency. Stated another way, focus on any single such material parameter in the design of a multijunction solar cell is not a viable design paradigm or calculus since each variable standing alone is NOT a simple "result effective variable" that can be mindlessly increased or decreased in order to achieve greater power output by those skilled in the art confronted with complex design specifications and practical operational considerations or related design objectives.

To reinforce the above observation, the present disclosure identifies a combination of two electrical parameters associated with a subcell and notes how the value of the combination changes over the operational lifetime of the solar cell, which is different for each subcell (since each subcell has a different band gap).

The electrical parameter of consideration taught by the present disclosure is the difference between the band gap and the open circuit voltage, or (Eg/q - Voc), of a particular active layer. The value of such parameter may vary depending on subcell layer thicknesses, doping, the composition of adjacent layers (such as tunnel diodes), and even the specific wafer being examined from a set of wafers processed on a single supporting platter in a reactor run, but consideration of that parameter has led to new design paradigms which enable improvement in the end-of-life efficiency of a multijunction solar cell.

Another important mechanical or structural consideration in the choice of semiconductor layers for a solar cell is the desirability of the adjacent layers of semiconductor materials in the solar cell, i.e. each layer of crystalline semiconductor material that is deposited and grown to form a solar subcell, have similar or substantially similar crystal lattice constants or parameters.

Here again there are trade-offs between including specific elements in the composition of a layer which may result in improved voltage associated with such subcell and therefore potentially a greater power output, and deviation from exact crystal lattice matching with adjoining layers as a consequence of including such elements in the layer which may result in a higher probability of defects, and therefore lower manufacturing yield.

In that connection, it should be noted that there is no strict definition of what is understood to mean two adjacent layers are "lattice matched" or "lattice mismatched". For purposes in this disclosure, "lattice mismatched" refers to two adjacently disposed materials or layers (with thicknesses of greater than 100 nm) having in-plane lattice constants of the materials in their fully relaxed state differing from one another by more than 0.1% in lattice constant. (Applicant notes that this definition is considerably more stringent than that proposed, for example, in U.S. Patent No. 8,962,993, which suggests more than 0.6% lattice constant difference as defining "lattice mismatched" layers).

The present disclosure proposes design features for multijunction solar cells which depart from such conventional wisdom for increasing the efficiency of the multijunction solar cell in converting solar energy (or photons) to electrical energy and optimizing such efficiency at the "end-of-life" period, rather than at the "beginning-of-life" (BOL).

In addition to implementing a lattice mismatching designed paradigm, another concern in the conventional wisdom is the use of compounds like aluminum which exacerbates material quality, and therefore when used in substantial quantics per mole fraction has a negative effect on the efficiency and manufacturability of the solar cell.

The present disclosure proposes further new design features by implementing as many high band gap subcells as possible to increase the solar cell efficiency, notwithstanding that specifying such high band gap subcells require the use of increasing amounts of aluminum in such subcells, contrary to the conventional wisdom, and more particularly optimizing the range of aluminum incorporated in the top two solar subcells.

### SUMMARY OF THE DISCLOSURE

It is an object of the present disclosure to increase the efficiency of solar cells by including a high degree of aluminum in a limited range in the upper solar subcells so as to increase their bandgap.

It is another object of the present disclosure to provide a metamorphic multijunction solar cell in which increased amounts of aluminum have been included in the composition of one or more subcells so that their band gaps have been designed to maximize the photoconversion efficiency of the solar cell.

It is another object of the present disclosure to provide in a multijunction solar cell in which the selection of the composition of the subcells and their band gaps maximizes the efficiency of the solar cell at a predetermined temperature (in the range of 28 to 70 degrees Centigrade) and radiation environment in deployment in space at AM0 at a predetermined time after the initial deployment, such time being at least (i) one year; (ii) five years; (iii) ten years; or (iv) fifteen years, in a specific orbit or space mission.

It is another object of the present disclosure to provide an upright, tandem four or five junction solar cell with one metamorphic layer in which the average band gap of all cells (i.e., the sum of the individual four or five band gaps of each of the subcells, divided by four or five) is greater than (i) 1.44 eV; or (ii) 1.35 eV; or (iii) 1.30 eV; or (iv) 1.25 eV.

It is another object of the present disclosure to provide a lattice mismatched four junction solar cell in which the current through the bottom subcell is intentionally designed to be substantially greater than current through the top three subcells when measured at the "beginning-of-life" or time of initial deployment.

Some implementations of the present disclosure may incorporate or implement fewer of the aspects and features noted in the foregoing objects.

A technical objective provided by examples in the present disclosure may be regarded as increasing the efficiency and performance of a multijunction solar cell, in particular, at the "end-of-life" after the solar cell has subjected to radiation at the level of 1 × 10¹⁵ e/cm² (or "1E15") at 70° C or more.

Another challenge to be addressed by the present disclosure may be described as how to increase the efficiency and performance of a multijunction solar cell after subjection to radiation as experienced in a variety of earth orbits which has a deleterious effect on the current produced by certain solar subcells exposed to radiation, which therefore results in lower overall power produced by the solar cell.

### Features of the Disclosure

All ranges of numerical parameters set forth in this disclosure are to be understood to encompass any and all subranges or "intermediate generalizations" subsumed therein. For example, a stated range of "1.0 to 2.0 eV" for a band gap value should be considered to include any and all subranges beginning with a minimum value of 1.0 eV or more and ending with a maximum value of 2.0 eV or less, e.g., 1.0 eV to 1.2 eV, or 1.3 eV to 1.4 eV, or 1.5 eV to 1.9 eV.

Briefly, and in general terms, the present disclosure provides a multijunction solar cell (and its method of manufacture) comprising: a growth substrate; a first solar subcell disposed over or in the growth substrate; a tunnel diode disposed over the first solar subcell; a graded interlayer directly disposed over the tunnel diode; a sequence of layers of semiconductor material disposed over the graded interlayer comprising one or more middle solar subcells including a second solar subcell disposed over and lattice mismatched with respect to the growth substrate; wherein the graded interlayer has a band gap equal to or greater than that of the second subcell and is compositionally graded to lattice match the growth substrate on one side and the second subcell on the other side; and being composed of any of the As, P, N, Sb based III-V compound semiconductors subject to the constraints of having the in-plane lattice parameter in each of the sublayers of the graded interlayer throughout its thickness being greater than the lattice constant of the growth substrate; and an upper solar subcell disposed over the middle solar subcells and having a band gap in the range of 1.95 eV to 2.20 eV; wherein either the upper solar subcell, or the middle solar subcell directly below the upper solar subcell, or both, has an aluminum content in excess of 17.5% by mole fraction, but less than 25%.

It is noted herein the numbering of the solar subcells can, but does not necessarily relate to the order of deposition of layers. Particularly, it is intended to cover both (non-inverted) "upright" solar cells and inverted metamorphic multijunction solar cells. Rather, the upper or "top" solar subcell is arranged closest to the light receiving end whereas the first solar subcell is furthest removed from the light receiving end and may also be referred to as "bottom" solar subcell. E.g. in an inverted four junction solar cell, the fourth (or upper) solar subcell may thus be the first subcell that is deposited or grown in a manufacturing process, and the first solar subcell may be the last subcell that is deposited or grown.

The multijunction solar cells of the present disclosure may be triple junction solar cells, or four or five junction solar cells.

In some embodiments, the upper solar subcell has an aluminum content in excess of 17.5% by mole fraction; or optionally in excess of 20% by mole fraction. In some embodiments, the middle solar subcell directly below the upper solar subcell has an aluminum content in excess of 20% by mole fraction; but less than 25%.

In some embodiments, the third and fourth solar subcells are lattice matched to the second solar subcell.

In some embodiments, the second solar subcell has a band gap in the range of 1.06 eV to 1.41 eV; the third solar subcell has a band gap in the range of approximately 1.35 eV to 1.70 eV; and the fourth or upper subcell disposed over the third solar subcell has an aluminum content in excess of 20% by mole fraction, a band gap in the range of 1.95 eV to 2.20 eV.

In some embodiments, the fourth or upper solar subcell is composed of indium gallium aluminum phosphide; the third solar subcell is composed of (aluminum) indium gallium arsenide; the third solar subcell includes an emitter layer composed of indium, gallium, phosphide or aluminum, indium, gallium, arsenide, and a base layer composed of aluminum, indium, gallium, arsenide; the second solar subcell is composed of indium, gallium, arsenide, the first solar subcell is composed of germanium; and the graded interlayer is composed of (InₓGa₁₋ₓ)_{y}Al_{1-y}As with 0 < x < 1, 0 < y < 1, and in some embodiments, the band gap of the graded interlayer is constant throughout its thickness.

In some embodiments, the upper solar subcell is composed of a semiconductor compound including at least aluminum, indium and phosphorus, and having an aluminum content in excess of 17.5% by mole fraction, and a band gap in the range of 1.95 eV to 2.20 eV.

In some embodiments, the third solar subcell is composed of a semiconductor compound including at least indium, gallium, arsenic and phosphorus.

In another aspect the present disclosure provides a multijunction solar cell (and its method of manufacture) comprising: a growth substrate; a first solar subcell disposed over or in the growth substrate; a sequence of layers of semiconductor material disposed over the growth substrate comprising one or more middle solar subcells including a second solar subcell disposed over and lattice matched with respect to the growth substrate; and an upper solar subcell disposed over the middle solar subcell and having an aluminum content in excess of 17.5% by mole fraction, and a band gap in the range of 1.95 eV to 2.20 eV. The upper solar subcell may be lattice matched to the last middle solar subcell.

In some embodiments, the multijunction solar cell comprises: a germanium growth substrate; a first solar subcell disposed over or in the growth substrate; a graded interlayer disposed over the growth substrate, followed by a sequence of layers of semiconductor material comprising a plurality of solar subcells including: a first middle subcell disposed over and lattice mismatched with respect to the growth substrate and having a band gap in the range of 1.0 eV to 1.41 eV; a second middle subcell disposed over the first middle subcell and having a band gap in the range of approximately 1.35 to 1.66 eV; a third middle subcell disposed over the second middle subcell and lattice mismatched with respect to the growth substrate and having a band gap in the range of 1.665 eV to 1.95 eV; and an upper solar subcell disposed over the last middle subcell and having an aluminum content in excess of 17.5% by mole fraction, and a band gap in the range of 1.95 eV to 2.20 eV.

In another aspect, the present disclosure provides a method of manufacturing a multijunction solar cell comprising: providing a growth substrate; forming a first solar subcell in the growth substrate; growing a graded interlayer over the growth substrate, followed by growing a sequence of layers of semiconductor material using a disposition process to form a solar cell comprising a plurality of subcells including a first middle solar subcell disposed over and lattice mismatched with respect to the growth substrate and having a band gap in the range of 1.3 eV to 1.6 eV, at least a second middle subcell disposed over the first middle solar subcell and having a band gap In the range of approximately 1.65 eV to 1.8 eV, and an upper solar subcell disposed over the last middle subcell and having a band gap in the range of 2.0 eV to 2.20 eV.

In some embodiments of a four or five junction solar cell, the upper solar subcell is composed of indium, gallium, aluminum phosphide; the third solar subcell includes an emitter layer composed of indium, gallium phosphide or aluminum, gallium, arsenide, and a base layer composed of indium, aluminum, gallium, arsenide or an indium, gallium, arsenide, phosphide base and emitter layer, with the base layer and the emitter layer forming a photovoltaic junction; the second solar subcell is composed of indium gallium arsenide; the first solar subcell is composed of germanium; and the graded interlayer is composed of InₓGa_{1-x-y}Al_{y}As with 0 < x < 1, 0 < y < 1.

More specifically, in some embodiments the present disclosure is directed to an improved design of a four junction upright metamorphic solar cell in which the second solar subcell (in the detailed description referred to as solar subcell "C") with a bandgap in the range of 1.0 eV to 1.35 eV and composition of InGaAs, has been subject to radiation at a level of 1E15 at 70° C, with the design paradigm of utilizing relatively high band gaps in the top or upper subcells by using a substantial amount of aluminum in their composition to increase the bandgaps.

In some embodiments, the upper solar subcell is composed of a semiconductor compound including at least aluminum, indium, and phosphorus.

In some embodiments, the last middle solar subcell (directly below the upper solar subcell) is composed of a semiconductor compound including at least indium, gallium, arsenic and phosphorus.

In some embodiments, the band gap of the graded interlayer remains at a constant value in the range of 1.22 eV to 1.75 eV throughout its thickness.

In some embodiments, the concentration of aluminum in the graded interlayer remains constant at a value in the range of 5 to 25% throughout its thickness.

In some embodiments, a four junction solar cell is provided, in which the first solar subcell or growth substrate has a band gap in the range of approximately 0.67 eV, the second solar subcell (the first middle solar subcell) has a band gap of approximately 1.41 eV, the third solar subcell (the second middle solar subcell) has a band gap in the range of approximately 1.65 to 1.8 eV, and the upper solar subcell has a band gap in the range of 2.0 eV to 2.20 eV.

Another descriptive aspect of the present disclosure is to characterize the fourth solar subcell as having a direct band gap of greater than 0.75 eV. The indirect band gap of germanium at room temperature is about 0.67 eV, while the direct band gap of germanium at room temperature is about 0.8 eV. Those skilled in the art will normally refer to the "band gap" of germanium as 0.67 eV, since it is lower than the direct band gap value of 0.8 eV.

The recitation that "the fourth subcell has a direct band gap of greater than 0.75 eV" is therefore expressly meant to include germanium as a possible semiconductor for the fourth subcell, although other semiconductor material can be used as well.

In some embodiments, the second middle subcell has a band gap of approximately 1.66 eV and the upper subcell has a band gap of approximately 1.95 eV.

In some embodiments of a five junction solar cell the bottom subcell or growth substrate is composed of germanium, the first middle subcell (i.e. the second solar subcell) is composed of indium, gallium, arsenide; the second middle solar subcell (i.e. the third solar subcell) includes an emitter layer composed of indium, gallium phosphide or aluminum indium gallium arsenide, and a base layer composed of aluminum, indium, gallium arsenide; the third middle solar subcell (i.e. the fourth solar subcell) is composed of (aluminum) indium gallium phosphide or an AlInGaAs with a InGaP emitter; and the upper subcell (i.e. the fifth solar subcell) is composed of aluminum, indium, gallium, phosphide. The use of a chemical element in parenthesis, such as (aluminum), indicates that the identified element is optional.

In some embodiments of a five junction solar cell, the first solar subcell has a band gap of approximately 0.67 eV, the first middle subcell (i.e. the second solar subcell) has a band gap in the range of 1.0 eV to 1.41 eV, the second middle subcell (i.e. the third solar subcell) has a band gap in the range of 1.35 to 1.66 eV, but greater than the first middle subcell, the third middle subcell (i.e. the fourth solar subcell) has a band gap in the range of 1.665 to 1.95 eV and the upper subcell has a band gap in the range of 1.95 to 2.20 eV.

In some embodiments, a distributed Bragg reflector (DBR) structure is provided adjacent to and between the second and the third solar subcells and composed of a plurality of alternating layers of lattice mismatched materials with discontinuities in their respective indices of refraction and arranged so that light can enter and pass through the third solar subcell and at least a first portion of which light having a first spectral width wavelength range, including the band gap of the third solar subcell, can be reflected back into the third solar subcell by the DBR structure, and a second portion of which light in a second spectral width wavelength range corresponding to longer wavelengths than the first spectral width wavelength range can be transmitted through the DBR structure to the second and further solar subcells disposed beneath the DBR structure.

In some embodiments, the tunnel diode is directly grown over the growth substrate or the first solar subcell, with the graded interlayer directly grown over the tunnel diode, and the DBR structure is grown over the graded interlayer.

In some embodiments, the graded interlayer is directly grown over the growth substrate or the first solar subcell with the tunnel diode directly grown over the graded interlayer, and the DBR structure grown over the tunnel diode.

In some embodiments, the DBR structure is directly grown over the growth substrate or the first solar subcell with the graded interlayer directly grown over the DBR structure, and a tunnel diode grown over the graded interlayer.

In some embodiments, the DBR structure is directly grown over the growth substrate or the first solar subcell with the tunnel diode directly grown over the DBR structure, and the graded interlayer is grown over the tunnel diode.

In some embodiments, the graded interlayer is directly grown over the growth substrate or first solar subcell with the DBR structure directly grown over the graded interlayer, and the tunnel diode grown over the DBR structure.

In some embodiments, the tunnel diode is directly grown over the growth substrate or first solar subcell, with the DBR structure directly grown over the tunnel diode, and the graded interlayer grown over the DBR structure.

In some embodiments, the difference in refractive indices between the alternating layers in the DBR structure is maximized in order to minimize the number of periods required to achieve a given reflectivity, and the thickness and refractive index of each period of the DBR structure determines the stop band and its limiting wavelength, and wherein the DBR structure includes a first DBR sublayer composed of a plurality of n-type or p-type InₓGa_{1-x-y}Al_{y}As layers, where 0 < x < 1, 0 < y < 1, and a second DBR sublayer disposed over the first DBR sublayer and composed of a plurality of n-type or p-type InₓGa_{1-x-z}Al_{z}As layers, where 0 < x < 1, 0 < z < 1, and z is greater than x.

In some embodiments, one or more of the subcells (i) have a base region having a gradation in doping that increases exponentially from a value in the range of 1 × 10¹⁵ to 1 × 10¹⁸ free carriers per cubic centimeter adjacent the p-n junction to a value in the range of 1 × 10¹⁶ to 4 × 10¹⁸ free carriers per cubic centimeter adjacent to the adjoining layer at the rear of the base, and (ii) have an emitter region having a gradation in doping that decreases from a value in the range of approximately 5 × 10¹⁸ to 1 × 10¹⁷ free carriers per cubic centimeter in the region immediately adjacent the adjoining layer to a value in the range of 5 × 10¹⁵ to 1 × 10¹⁸ free carriers per cubic centimeter in the region adjacent to the p-n junction of the one subcell.

In some embodiments, a layer of InGaAs, GaAsSb, InAsP, InAIAs, or SiGeSn, InGaAsN, InGaAsNSb, InGaAsNBi, InGaAsNSbBi, InGaSbN, InGaBiN or InGaSbBiN is deposited over the growth substrate.

In some embodiments, the selection of the composition of the subcells and their band gaps maximizes the efficiency of the solar cell at a predetermined temperature value (between 28 and 70 degrees Centigrade) at a predetermined time after the initial deployment in space, (the time of the initial deployment being referred to as the "beginning-of-life (BOL)"), such predetermined time being referred to as the "end-of-life (EOL)" time, and such time being at least one year.

In some embodiments, the selection of the composition of the subcells and their band gaps maximizes the efficiency of the solar cell at a predetermined low intensity (less than 0.1 suns) and low temperature value (less than 100 degrees Centigrade) in deployment in space at a predetermined time after the initial deployment in space, or the "beginning-of-life (BOL)", such predetermined time being referred to as the "end-of-life (EOL)" time, and being at least one year.

In some embodiments, the maximization of solar cell efficiency at EOL is achieved by a design paradigm, wherein the composition of the subcells are not designed to maximize the solar cell efficiency at the BOL, but to increase the solar cell efficiency at the EOL while disregarding the solar cell efficiency at the BOL, such that the solar cell efficiency at the BOL is less than the solar cell efficiency at the BOL that would be achieved if the selection were designed to maximize the solar cell efficiency at the BOL.

In some embodiments of a four junction solar cell, the average band gap of all four subcells (i.e., the sum of the four band gaps of each subcell divided by four) is greater than 1.44 eV; or optionally is greater than 1.35 eV; or optionally is greater than 1.30 eV; or optionally is greater than 1.25 eV.

In some embodiments, in a four junction solar cell, the band gap of the second subcell is approximately 1.35 eV and the average band gap of all four subcells (i.e., the sum of the four band gaps of each subcell divided by four) is greater than 1.25 eV; or optionally, the band gap of the second subcell is approximately 1.30 eV and the average band gap of all four subcells (i.e., the sum of the four band gaps of each subcell divided by four) is greater than 1.25 eV; or optionally, the band gap of the second subcell is approximately 1.25 eV and the average band gap of all four subcells (i.e., the sum of the four band gaps of each subcell divided by four) is greater than 1.25 eV.

In some embodiments, in a four junction solar cell, the band gap of the second solar subcell (i.e. the first middle subcell) is approximately 1.25 eV and the average band gap of all four subcells (i.e. the sum of the four band gaps of each subcell divided by four) is greater than 1.25 eV.

In some embodiments, the first solar subcell has a band gap of approximately 0.67 eV, the second solar subcell has a band gap of 1.41 eV or less, the third solar subcell has a band gap of approximately 1.55 to 1.8 eV and the fourth or upper solar subcell has a band gap in the range of 2.0 to 2.2 eV.

In some embodiments, the third solar subcell has a band gap of approximately 1.73 eV and the fourth or upper solar subcell has a band gap of approximately 2.10 eV.

In some embodiments, the fourth or upper solar subcell has a band gap of approximately 2.05 to 2.10 eV, the third solar subcell has a band gap in the range of 1.55 to 1.73 eV; and the second solar subcell has a band gap in the range of 1.15 to 1.41 eV.

In some embodiments, the upper solar subcell has a band gap of approximately 2.10 eV, the second solar subcell has a band gap of approximately 1.73 eV; and the third solar subcell has a band gap of approximately 1.41 eV.

In some embodiments, the fourth or upper solar subcell has a band gap of approximately 2.10 eV, the third solar subcell has a band gap of approximately 1.65 eV; and the second solar subcell has a band gap of approximately 1.3 eV.

In some embodiments, the fourth or upper solar subcell has a band gap of approximately 2.05 eV, the third solar subcell has a band gap of approximately 1.55 eV; and the second solar subcell has a band gap of approximately 1.2 eV.

In some embodiments of a four junction solar cell, the fourth or upper solar subcell has a band gap of approximately 2.05 eV.

In some embodiments of a four junction solar cell, the band gap of the second solar subcell is less than 1.41 eV, and greater than that of the first solar subcell.

In some embodiments of a four junction solar cell, the second solar subcell has a band gap in the range of 1.15 to 1.35 eV; or optionally a band gap in the range of 1.1 to 1.2 eV.

In some embodiments of a four junction solar cell, the second solar subcell has a band gap of approximately 1.1 eV to 1.2 eV.

In some embodiments of a four junction solar cell, the second solar subcell has a band gap of approximately 1.2 eV.

In some embodiments, the first solar subcell has a band gap of 0.67 eV, the second solar subcell has a band gap in the range of approximately 1.41 eV, the third solar subcell has a band gap in the range of approximately 1.6 to 1.8 eV and the fourth or upper solar subcell has a band gap in the range of 2.0 to 2.20 eV.

In some embodiments, the first solar subcell has a band gap of 0.67 eV, the second subcell has a band gap of approximately 1.41 eV, the third subcell has a band gap of 1.736 eV and the fourth or upper solar subcell has a band gap of 2.1eV.

In some embodiments, the first solar subcell has a band gap of 0.67 eV, the second middle subcell has a band gap of approximately 1.265 eV, the third middle subcell has a band gap of approximately 1.88 eV and the fourth or upper solar subcell has a band gap of approximately 2.1 eV.

In some embodiments, the third subcell has a band gap of approximately 1.73 eV and the fourth or upper solar subcell has a band gap of approximately 2.10 eV.

In some embodiments of a five junction solar cell, the first solar subcell has a band gap of 0.67 eV, the second solar subcell has a band gap in the range of 1.06 eV to 1.41 eV, the third solar subcell has a band gap in the range of 1.35 eV to 1.66 eV but greater than the second solar subcell, the fourth solar subcell has a band gap in the range of 1.665 to 1.95 eV and the fifth or upper solar subcell has a band gap in the range of 1.95 eV to 2.20 eV but greater than that of the fourth solar subcell.

In another aspect, the present disclosure provides a four junction solar cell comprising an upper fourth solar subcell composed of a semiconductor material having a fourth band gap; a third solar subcell adjacent to said fourth solar subcell and composed of a semiconductor material having a third band gap smaller than the fourth band gap and being lattice matched with the upper fourth solar subcell; a second solar subcell adjacent to said third solar subcell and composed of a semiconductor material having a second band gap smaller than the third band gap and being lattice matched with the third solar subcell; and a first solar subcell adjacent to and lattice mismatched to said second solar subcell and composed of a semiconductor material having a first band gap smaller than the second band gap; wherein the average band gap of all four subcells (i.e., the sum of the four band gaps of each subcell divided by four) is greater than 1.35 eV, or optionally greater than 1.44 eV.

In another aspect, the present disclosure provides a four junction solar cell comprising an upper fourth solar subcell composed of a semiconductor material having a fourth band gap; a third solar subcell adjacent to said fourth solar subcell and composed of a semiconductor material having a third band gap smaller than the fourth band gap and being lattice matched with the upper fourth solar subcell; a second solar subcell adjacent to said third solar subcell and composed of a semiconductor material having a second band gap smaller than the third band gap and being lattice matched with the third solar subcell; a graded interlayer adjacent to said second solar subcell, said graded interlayer having a band gap greater than said second band gap; and a first solar subcell adjacent to said second solar subcell and composed of a semiconductor material having a first band gap smaller than the band gap of the graded interlayer and being lattice mismatched with the second solar subcell; wherein the graded interlayer is compositionally graded to lattice match the second solar subcell on one side and the lower first solar subcell on the other side, and is composed of any of the As, P, N, Sb based III - V compound semiconductors subject to the constraints of having the in-plane lattice parameter less than or equal to that of the second solar subcell and greater than or equal to that of the lower first solar subcell; wherein the first subcell has a direct band gap of greater than 0.75 eV.

In another aspect, the present disclosure provides a method of manufacturing a four junction solar cell comprising providing a germanium substrate; growing on the germanium substrate a sequence of layers of semiconductor material using a semiconductor disposition process to form a solar cell comprising a plurality of solar subcells including a metamorphic layer, a second subcell disposed over the metamorphic layer and having a band gap of approximately 1.41 eV, a third subcell disposed over the second subcell and having a band gap in the range of approximately 1.6 eV to 1.8 eV, and an upper (fourth) subcell disposed over the third subcell and having a band gap in the range of 2.0 eV to 2.20 eV.

In some embodiments, the method of manufacturing further comprises forming (i) a back surface field (BSF) layer disposed directly adjacent to the bottom surface of the second subcell, and (ii) at least one distributed Bragg reflector (DBR) layer directly below the BSF layer so that light can enter and pass through the subcells above the second solar subcell and at least a portion of which be reflected back into the second subcell by the DBR layer.

In some embodiments, additional layer(s) may be added or deleted in the cell structure without departing from the scope of the present disclosure.

Some implementations of the present disclosure may incorporate or implement fewer of the aspects and features noted in the foregoing summaries.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teachings herein will recognize additional applications, modifications and embodiments in other fields, which are within the scope of the disclosure as disclosed and claimed herein and with respect to which the disclosure could be of utility.

### BRIEF DESCRIPTION OF THE DRAWINGS

The disclosure will be better and more fully appreciated by reference to the following detailed description when considered in conjunction with the accompanying drawings, wherein:
FIG. 1 is a graph representing the value of the BOL parameter E_{g}/q - V_{oc} at 28° C plotted against the band gap of certain binary materials defined along the x-axis;
FIG. 2 is a cross-sectional view of a first embodiment of a four junction solar cell after several stages of fabrication including the growth of certain semiconductor layers on the growth substrate up to the contact layer, according to the present disclosure;
FIG. 3A is a cross-sectional view of a second embodiment of a four junction solar cell after several stages of fabrication including the growth of certain semiconductor layers on the growth substrate up to the contact layer, according to the present disclosure;
FIG. 3B is a cross-sectional view of a fourth embodiment of a four junction solar cell after several stages of fabrication including the growth of certain semiconductor layers on the growth substrate up to the contact layer, according to the present disclosure; and
FIG. 4 is a graph of the doping profile in the base and emitter layers of a subcell in the solar cell according to the present disclosure.

### DESCRIPTION OF THE PREFERRED EMBODIMENTS

Details of the present disclosure will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

A variety of different features of multijunction solar cells (as well as inverted metamorphic multijunction solar cells) are disclosed in the related applications noted above. Some, many or all of such features may be included in the structures and processes associated with the non-inverted or "upright" solar cells of the present disclosure. However, more particularly, the present disclosure is directed to the fabrication of a multijunction lattice mis-matched solar cell grown over a metamorphic layer which is grown on a single growth substrate. More specifically, however, in some embodiments, the present disclosure relates to four or five junction solar cells with direct band gaps in the range of 2.0 eV to 2.15 eV (or higher) for the top subcell with an aluminum content in excess of 17.5% but less than 25% by mole fraction, and (i) 1.6 eV to 1.8 eV, and (ii) 1.41 eV for the middle subcells, and 0.6 eV to 0.8 eV indirect band gap for the bottom subcell, respectively.

The conventional wisdom for many years has been that in a monolithic multijunction tandem solar cell, "... the desired optical transparency and current conductivity between the top and bottom cells... would be best achieved by lattice matching the top cell material to the bottom cell material. Mismatches in the lattice constants create defects or dislocations in the crystal lattice where recombination centers can occur to cause the loss of photogenerated minority carriers, thus significantly degrading the photovoltaic quality of the device. More specifically, such effects will decrease the open circuit voltage (V_{oc}), short circuit current (J_{sc}), and fill factor (FF), which represents the relationship or balance between current and voltage for effective output" (Jerry M. Olson, U.S. Patent No. 4,667,059, "Current and Lattice Matched Tandem Solar Cell").

As progress has been made toward higher efficiency multijunction solar cells with four or more subcells, nevertheless, "it is conventionally assumed that substantially lattice-matched designs are desirable because they have proven reliability and because they use less semiconductor material than metamorphic solar cells, which require relatively thick buffer layers to accommodate differences in the lattice constants of the various materials" (Rebecca Elizabeth Jones - Albertus et al., U.S. Patent No. 8,962,993).

Even more recently "...current output in each subcell must be the same for optimum efficiency in the series-- connected configuration" (Richard R. King et al., U.S. Patent No. 9,099,595).

The present disclosure provides an unconventional four junction design (with three grown lattice matched subcells, which in turn are lattice mismatched to the Ge substrate) that leads to significant performance improvement in an AM0 spectral environment over that of a traditional three junction solar cell on Ge despite the lattice mismatch and substantial current mismatch between the top three subcells and the bottom Ge subcell. This performance gain is especially realized at high temperature and after high exposure to space radiation as a result of the proposal of the present disclosure to incorporate high band gap semiconductors that are inherently more resistant to radiation and temperature in spite of the disadvantages associated with lattice mismatch and current mismatch, and the use of substantial amounts of aluminum in at least the upper solar subcell, the solar subcell directly below the upper solar subcell, or both.

While the conventional wisdom suggests that the selection of the composition, band gaps, and thickness of each subcell is designed to ensure that the current is matched when operated in an AM0 spectral environment, the present design departs from that teaching and utilizes a design employing higher band gaps than the conventional design, and accordingly, a current mismatch between the upper subcells and the bottom subcell that is substantially greater than current commercial products or other proposed designs.

Although the advance of the present disclosure may be broadly characterized as the deliberate use of lattice mismatching and substantial current mismatching between subcells and high aluminum content in at least one of the two upper solar subcells, in a three junction, four junction or five junction solar cell, instead of simply specifying the amount of aluminum (by a mole fraction percentage) in a given solar subcell, another way of characterizing the present disclosure is that in some embodiments of an upright metamorphic multijunction solar cell, the average band gap of all subcells (i.e., the sum of the band gaps of each subcell divided by three, four or five) is greater than a specific value, e.g. 1.44 eV, or optionally 1.30 eV, or optionally 1.25 eV.

The exemplary solar cell described herein may require the use of aluminum in the semiconductor composition in the upper solar subcell, or in each of the top two subcells. For example, in some cases, the upper solar subcell may have an aluminum content in different embodiments, (i) in excess of 20% by mole fraction, or (ii) in excess of 17.5% by mole fraction, but in either case below 25%. Likewise, in some cases, the middle solar subcell adjacent to the upper solar subcell may have an aluminum content in excess of 20% by mole fraction, or (iii) in excess of 17.5% by mole fraction, but in either case below 25%.

Aluminum incorporation is widely known in the III-V compound semiconductor industry to degrade BOL subcell performance due to deep level donor defects, higher doping compensation, shorter minority carrier lifetimes, and lower cell voltage and an increased BOL E_{g}/q - V_{oc} metric also known as W_{oc} or the band gap voltage offset. In short, increased BOL E_{g}/q - V_{oc} may be the most problematic shortcoming of aluminum containing subcells; the other limitations can be mitigated by modifying the doping schedule or thinning base thicknesses.

One aspect of the present disclosure relates generally to the use of substantial amounts of aluminum in the active layers of the upper subcells in a multijunction solar cell. The effects of increasing amounts of aluminum as a constituent element in an active layer of a subcell affects the photovoltaic device performance. One measure of the "quality" or "goodness" of a solar cell subcell or junction is the difference between the band gap of the semiconductor material in that subcell or junction and the V_{oc}, or open circuit voltage, of that same junction. The smaller the difference, the higher the V_{oc} of the solar cell junction relative to the band gap, and the better the performance of the device. V_{oc} is very sensitive to semiconductor material quality, so the smaller the E_{g}/q - V_{oc} of a device, the higher the quality of the material in that device. There is a theoretical limit to this difference, known as the Shockley-Queisser limit. That is the best that a solar cell junction can be under a given concentration of light at a given temperature.

As was noted above, the degradation of the material quality by increasing Al content results in a lower V_{oc} in the subcell, and therefore a lower efficiency and power output of the solar cell. However, a result of experiments conducted by Applicants, a surprising technical effect has been recognized by Applicants in that by using a substantial amount of aluminum, e.g. over 17.5 % by mole fraction, but less than 25% by mole fraction, in either or both of the top two solar subcells in a three, four or more multijunction solar cell, a substantial improvement in efficiency can be achieved compared to other solar subcell designs.

The implementation of such design paradigm is based on the use of combination of distinct design features including, but not limited to, the following:
(i) Utilizing three grown lattice matched subcells which are lattice mismatched to the germanium substrate; (In this context, lattice matching or lattice mismatching is defined as follows: "Lattice mismatched" refers to two adjacently disposed materials or layers (with thicknesses of greater than 100 nm) having in-plane lattice constants of the materials in their fully relaxed state differing from one another by more than 0.01% in lattice constant. (Applicant expressly adopts this definition for the purpose of this disclosure, and notes that this definition is considerably more stringent than that proposed, for example, in U.S. Patent No. 8,962,993, which suggests more than 0.6% lattice constant difference).
(ii) Utilizing sufficiently high quantities of aluminum in at least one of the top two solar subcells (hereafter referred to as the J1 and J2 solar subcells);
(iii) The selection of the composition of the subcells and their band gaps to maximize the efficiency of the solar cell at high temperature (in the range of 50 to 100 degrees Centigrade) in deployment in space at specific predetermined time after the "beginning of life" (BOL) or initial deployment (such specific later time referred to as the end-of-life (EOL), and being at least five years after the BOL, such selection being designated not to maximize the efficiency at BOL but to increase the solar cell efficiency at the EOL while disregarding the solar cell efficiency achieved at the BOL, such that the solar cell efficiency designed at the BOL is less than the solar call efficiency at the BOL that would be achieved if the selection were designed to maximize the solar cell efficiency at the BOL;
(iv) Matching the current in the top two or third subcells, but permitting a current mismatch when tested at the beginning of life, but after radiation exposure (i.e., at a predetermined "end-of-life" time frame) all three of the subcells will be current matched due to the different effect of the radiation on the different subcells;
(v) Providing somewhat greater thickness in the base layers of the J1 and J2 subcells to measure the band gaps while avoiding excessive thickness which would make such subcells lose current after radiation exposure; and
(vi) Adjusting the band gap in the active layers of each solar subcell by, for example, providing a higher band gap in the emitter region than in the base region of a given solar cell.

Such design features are independent parameters that the design paradigm using computer modelling and simulation may selectively adjust the band gaps, amount of aluminum, and subcell thickness to meet a specifically stated space mission objective - e.g., a maximization of the power output or efficiency of the solar cells at a given time period or EOL, or the cumulative power output over a defined period of time. Since such mission objectives - including orbital location or radiation exposure at specific periods of time - varies from mission to mission, or satellite to satellite, it is not possible to be more specific in the generic description in this disclosure. Thus, the specific band gaps of J1 and J2, and the amount of aluminum per mole fraction in each solar subcell would be adjusted and optimized to meet the mission requirement, all within the range of 17.5% to 25% Al per mole fraction.

As a consequence of the foregoing, in order to achieve higher power from the solar cell, the voltage in both J1 and J2 may be optimized, while permitting a current mismatch at BOL so as to achieve current matching at EOL. The amount of the increase in aluminum per mole fraction being greater in J2 than in J1 as a result of such design optimization as a specific technical requirement was unexpected and contrary to conventional wisdom, and is one of the characterizing features of the design paradigm of the present disclosure.

Some comments about metalorganic chemical vapor deposition (MOCVD) processes used in one embodiment are in order here.

It should be noted that the layers of a certain target composition in a semiconductor structure grown in an MOCVD process are inherently physically different than the layers of an identical target composition grown by another process, e.g. Molecular Beam Epitaxy (MBE). The material quality (i.e., morphology, stoichiometry, number and location of lattice traps, impurities, and other lattice defects) of an epitaxial layer in a semiconductor structure is different depending upon the process used to grow the layer, as well as the process parameters associated with the growth. MOCVD is inherently a chemical reaction process, while MBE is a physical deposition process. The chemicals used in the MOCVD process are present in the MOCVD reactor and interact with the wafers in the reactor, and affect the composition, doping, and other physical, optical and electrical characteristics of the material. For example, the precursor gases used in an MOCVD reactor (e.g. hydrogen) are incorporated into the resulting processed wafer material, and have certain identifiable electro-optical consequences which are more advantageous in certain specific applications of the semiconductor structure, such as in photoelectric conversion in structures designed as solar cells. Such high order effects of processing technology do result in relatively minute but actually observable differences in the material quality grown or deposited according to one process technique compared to another. Thus, devices fabricated at least in part using an MOCVD reactor or using a MOCVD process have inherent different physical material characteristics, which may have an advantageous effect over the identical target material deposited using alternative processes.

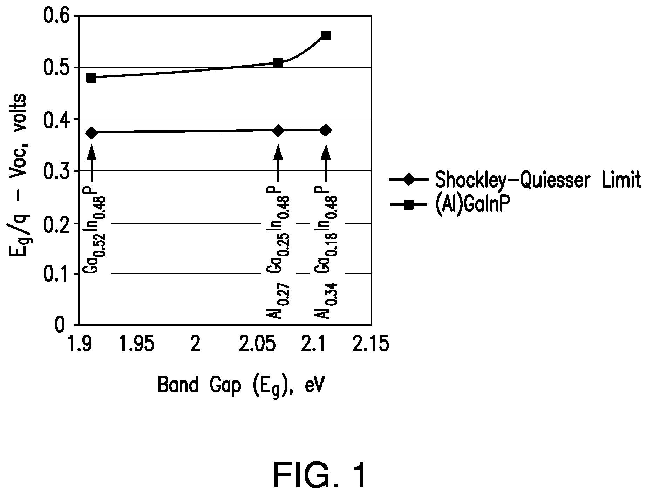

The experimental data obtained for single junction (Al)GaInP solar cells indicates that increasing the Al content of the junction leads to a larger V_{oc} - E_{g}/q difference, indicating that the material quality of the junction decreases with increasing Al content. FIG.1 shows this effect. The three compositions cited in the Figure are all lattice matched to GaAs, but have differing Al composition. Adding Al increases the band gap of the junction, but in so doing also increases V_{oc} - E_{g}/q. Hence, we draw the conclusion that adding Al to a semiconductor material degrades that material such that a solar cell device made out of that material does not perform relatively as well as a junction with less Al.

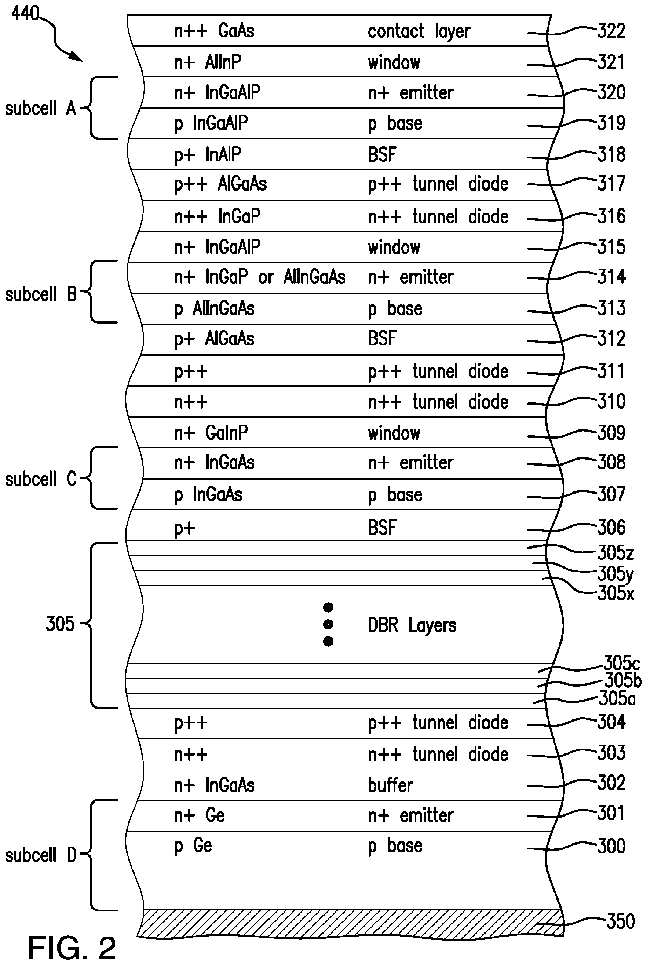

FIG. 2 illustrates a particular example of a multijunction solar cell device 440 according to the present disclosure.

As shown in the illustrated example of FIG. 2, the bottom subcell D preferably includes a substrate 300 formed of p-type germanium ("Ge") which also serves as a base layer. The bottom subcell may also be regarded as the first solar subcell.

A back metal contact pad 350 preferably formed on the bottom of base layer 300 provides electrical contact to the multijunction solar cell 440. The bottom subcell D, further includes, for example, a highly doped n-type Ge emitter layer 301, and preferably an n-type indium gallium arsenide ("InGaAs") buffer layer 302. The buffer layer 302 is deposited over the substrate 300, and the emitter layer 301 is formed in the substrate 300 preferably by diffusion of deposits into the Ge substrate 300, thereby forming the n-type Ge layer 301. Heavily doped p-type aluminum gallium arsenide ("AIGaAs") and preferably heavily doped n-type gallium arsenide ("GaAs") tunneling junction layers 304, 303 may be deposited over the buffer layer 300 to provide a low resistance pathway between the bottom and middle subcells.

Distributed Bragg reflector (DBR) layers 305 are preferably then grown adjacent to and between the tunnel diode 303, 304 of the bottom subcell D and the second solar subcell C. The DBR layers 305 are arranged so that light can enter and pass through the second solar subcell C and at least a portion of which can be reflected back into the second solar subcell C by the DBR layers 305. In the embodiment depicted in FIG. 2, the distributed Bragg reflector (DBR) layers 305 are preferably specifically located between the second solar subcell C and tunnel diode layers 304, 303; in other embodiments, the distributed Bragg reflector (DBR) layers may be located between tunnel diode layers 304/303 and the bottom solar subcell.

For some embodiments, distributed Bragg reflector (DBR) layers 305 preferably can be composed of a plurality of alternating layers 305a through 305z of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band.

For some embodiments, distributed Bragg reflector (DBR) layers 305a through 305z preferably includes a first DBR layer composed of a plurality of p- type AlₓGa₁₋ₓAs layers, and a second DBR layer disposed over the first DBR layer and preferably composed of a plurality of n or p-type Al_{y}Ga_{1-y}As layers, where 0 < x < 1, 0 < y < 1, and y is greater than x.

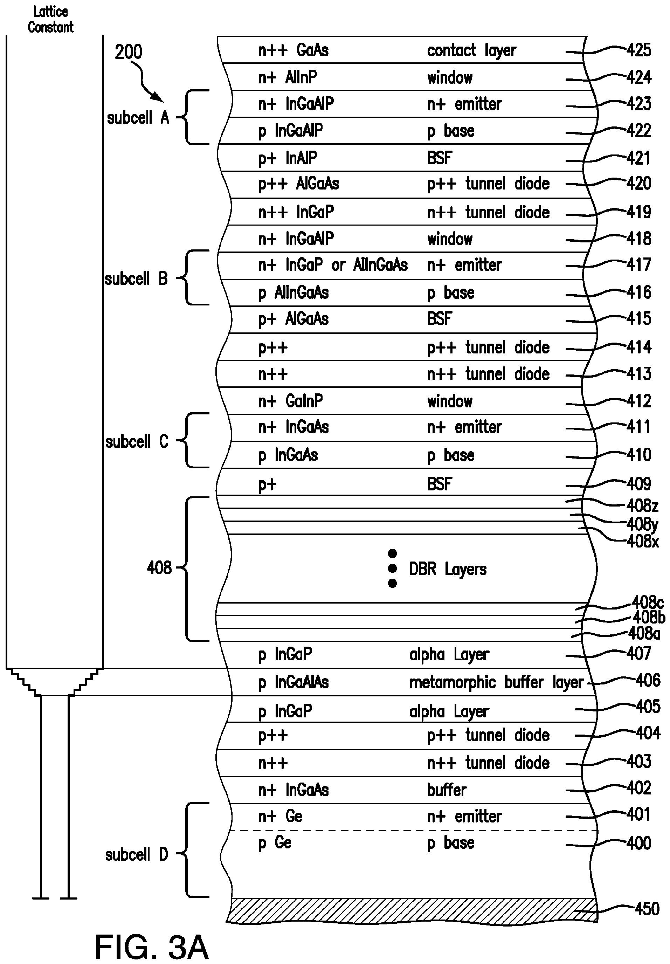

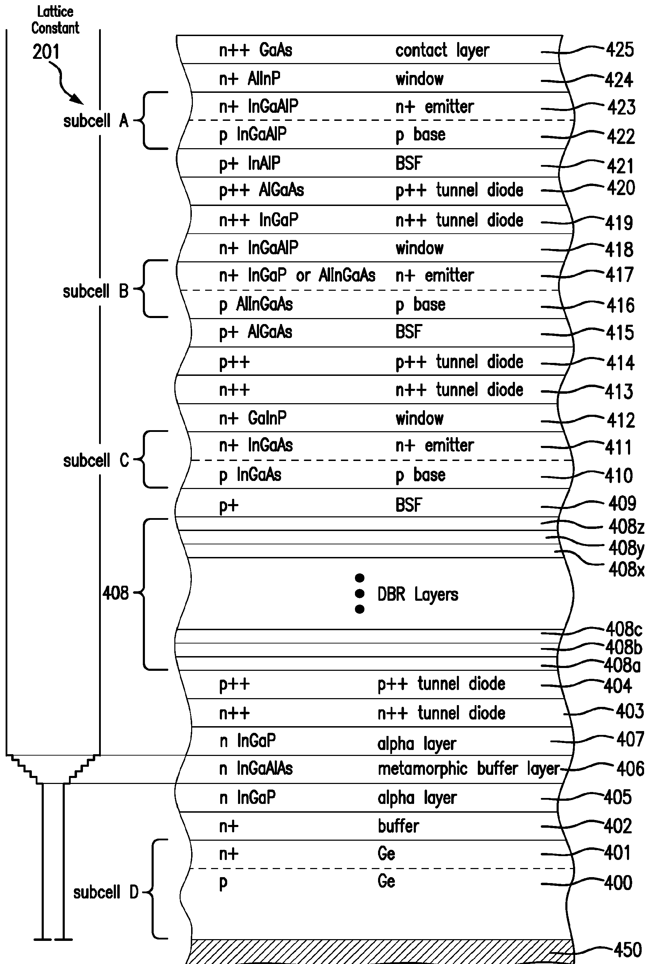

In the illustrated example of FIG. 3, the middle subcell C (second solar subcell in this example) includes a highly doped p-type aluminum gallium arsenide ("AIGaAs") back surface field ("BSF") layer 306, a p-type InGaAs base layer 307, a highly doped n-type indium gallium arsenide ("InGaAs") emitter layer 308 and a highly doped n-type indium aluminum phosphide ("AlInP2") or indium gallium phosphide ("GaInP") window layer 309. The InGaAs base layer 307 of the subcell C can include, for example, approximately 1.5% In. Other compositions may be used as well. The base layer 307 is preferably formed over the BSF layer 306 after the BSF layer is deposited over the DBR layers 305.

The window layer 309 is deposited on the emitter layer 308 of the subcell C. The window layer 309 in the subcell C also helps reduce the recombination loss and improves passivation of the cell surface of the underlying junctions. Before depositing the layers of the middle subcell B, heavily doped n-type InGaP and p-type AIGaAs (or other suitable compositions) tunneling junction layers 310, 311 may preferably be deposited over the subcell C.

The middle subcell B (third solar subcell in this example) preferably includes a highly doped p-type aluminum gallium arsenide ("AIGaAs") back surface field ("BSF") layer 312, preferably a p-type AlInGaAs base layer 313, preferably a highly doped n-type indium gallium phosphide ("InGaP₂") or AllnGaAs emitter layer 314 and preferably a highly doped n-type indium gallium aluminum phosphide ("AIGaAIP") window layer 315. The InGaP emitter layer 314 of the subcell B can include, for example approximately 50% In. Other compositions may be used as well.

In some embodiments, the middle subcell B may preferably be composed of InGaAsO.

Before depositing the layers of the top or upper cell A (fourth solar subcell in this example), heavily doped n-type InGaP and p-type AIGaAs tunneling junction layers 316, 317 may preferably be deposited over the subcell B.

In the illustrated example, the top subcell A preferably includes a highly doped p-type indium aluminum phosphide ("InAlP₂") BSF layer 318, preferably a p-type InGaAlP base layer 319, preferably a highly doped n-type InGaAlP emitter layer 320 and preferably a highly doped n-type InAlP₂ window layer 321. The base layer 319 of the top subcell A is preferably deposited over the BSF layer 318 after the BSF layer 318 is formed.

After the cap or contact layer 322 is deposited, the grid lines are preferably formed via evaporation and lithographically patterned and deposited over the cap or contact layer 322.

Turning to a second embodiment of the multijunction solar cell device of the present disclosure, FIG. 3A is a cross-sectional view of an embodiment of a four junction solar cell 200 after several stages of fabrication including the growth of certain semiconductor layers on the growth substrate up to the contact layer 425, with various subcells being similar to the structure described and depicted in FIG. 2. The generic structure of this embodiment essentially corresponds to Fig. 2 in related U.S. Patent Application Serial No. 15/681,144, filed August 18, 2017, now U.S. Patent No. 10,700,230.

As shown in the illustrated example of FIG. 3A, the bottom subcell D (or "first" solar subcell in this example) preferably includes a substrate 400 formed of p-type germanium ("Ge") which also serves as a base layer. A back metal contact pad 450 preferably formed on the bottom of base layer 400 provides electrical contact to the multijunction solar cell 500. The bottom subcell D, further includes, for example, preferably a highly doped n-type Ge emitter layer 401, and an n-type indium gallium arsenide ("InGaAs") buffer layer 402. The buffer layer is preferably deposited over the base layer, and the emitter layer is formed in the substrate by diffusion of deposits into the Ge substrate, thereby forming the n-type Ge layer 401. Heavily doped p-type aluminum gallium arsenide ("AIGaAs") and heavily doped n-type gallium arsenide ("GaAs") tunneling junction layers 403, 404 may be deposited over the buffer layer to provide a low resistance pathway between the bottom and middle subcells.

A first alpha layer 405, preferably composed of n-type AlGaInAsP, is deposited over the tunnel diode 403/404, preferably to a thickness of from 0.25 to about 1.0 micron. Such an alpha layer is intended to prevent threading dislocations from propagating, either opposite to the direction of growth into the bottom subcell D, or in the direction of growth into the second subcell C, and is more particularly described in U.S. Patent Application Pub. No. 2009/0078309 A1 (Cornfeld et al.).

A metamorphic layer (or graded interlayer) 406 is preferably deposited over the alpha layer 405 using a surfactant. Layer 406 is preferably a compositionally step-graded series of InGaAIAs layers, preferably with monotonically changing lattice constant, so as to achieve a gradual transition in lattice constant in the semiconductor structure from bottom subcell D to middle subcell C while minimizing threading dislocations from occurring. The band gap of layer 406 preferably is constant throughout its thickness, preferably approximately equal to 1.22 eV to 1.34 eV, or otherwise consistent with a value slightly greater than the band gap of the middle subcell C. One embodiment of the graded interlayer may also be expressed preferably as being composed of InₓGa₁₋ₓAs, with x and y selected such that the band gap of the interlayer remains constant preferably at approximately 1.22 eV to 1.34 eV or other appropriate band gap.

In some embodiments, in the surfactant assisted growth of the metamorphic layer 406, a suitable chemical element is preferably introduced into the reactor during the growth of layer 406 to improve the surface characteristics of the layer. In the preferred embodiment, such element may preferably be a dopant or donor atom such as selenium (Se) or tellurium (Te). Small amounts of Se or Te are therefore incorporated in the metamorphic layer 406, and remain in the finished solar cell. Although Se or Te are the preferred n-type dopant atoms, other non-isoelectronic surfactants may be used as well.

Surfactant assisted growth results in a much smoother or planarized surface. Since the surface topography affects the bulk properties of the semiconductor material as it grows and the layer becomes thicker, the use of the surfactants minimizes threading dislocations in the active regions, and therefore improves overall solar cell efficiency.

As an alternative to the use of non-isoelectronic one may preferably use an isoelectronic surfactant. The term "isoelectronic" refers to surfactants such as antimony (Sb) or bismuth (Bi), since such elements have the same number of valence electrons as the P atom of InGaP, or the As atom in InGaAIAs, in the metamorphic buffer layer. Such Sb or Bi surfactants will not typically be incorporated into the metamorphic layer 406.

In one embodiment of the present disclosure, the layer 406 is preferably composed of a plurality of layers of InGaAs, with monotonically changing lattice constant, each layer preferably having the same band gap, approximately preferably in the range of 1.22 eV to 1.34 eV. In some embodiments, the constant band gap is in the range of 1.27 eV to 1.31 eV. In some embodiments, the constant band gap is preferably in the range of 1.28 eV to 1.29 eV.

The advantage of utilizing a constant bandgap material such as InGaAs is that arsenide-based semiconductor material is much easier to process in standard commercial MOCVD reactors.

Although the preferred embodiment of the present disclosure preferably utilizes a plurality of layers of InGaAs for the metamorphic layer 406 for reasons of manufacturability and radiation transparency, other embodiments of the present disclosure may utilize different material systems to achieve a change in lattice constant from subcell C to subcell D. Other embodiments of the present disclosure may preferably utilize continuously graded, as opposed to step graded, materials. More generally, the graded interlayer may preferably be composed of any of the As, P, N, Sb based III - V compound semiconductors subject to the constraints of having the in-plane lattice parameter greater than or equal to that of the third solar cell and less than or equal to that of the second solar cell, and having a bandgap energy greater than that of the third solar cell.

In some embodiments, a second alpha layer 407, preferably composed of n+ type GalnP, is deposited over metamorphic buffer layer 406, preferably to a thickness of from 0.25 to about 1.0 micron. Such an alpha layer is intended to prevent threading dislocations from propagating, either opposite to the direction of growth into the subcell D, or in the direction of growth into the subcell C, and is more particularly described in U.S. Patent Application Pub. No. 2009/0078309 A1 (Cornfeld et al.).

Distributed Bragg reflector (DBR) layers 408 are preferably then grown adjacent to and between the alpha layer 407 and the second solar subcell C. The DBR layers 408 are arranged so that light can enter and pass through the second solar subcell C and at least a portion of which can be reflected back into the third solar subcell C by the DBR layers 408. In the embodiment depicted in FIG. 3A, the distributed Bragg reflector (DBR) layers 408 are specifically located between the second solar subcell C and second alpha layers 407; in other embodiments, the distributed Bragg reflector (DBR) layers may be located between first alpha layer 405 and tunnel diode layers 403/404.

For some embodiments, distributed Bragg reflector (DBR) layers 408 can be composed of a plurality of alternating layers 408a through 408z of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band.

For some embodiments, distributed Bragg reflector (DBR) layers 408a through 408z includes a first DBR layer composed of a plurality of p- type AlₓGa₁₋ₓAs layers, and a second DBR layer disposed over the first DBR layer and preferably composed of a plurality of p-type Al_{y}Ga_{1-y}As layers, where y is greater than x.

In the illustrated example of FIG. 3A, the subcell C preferably includes a highly doped p-type aluminum gallium arsenide ("AIGaAs") back surface field ("BSF") layer 409, preferably a p-type InGaAs base layer 410, preferably a highly doped n-type indium gallium phosphide ("InGaP2") emitter layer 411 and preferably a highly doped n-type indium aluminum phosphide ("AlInP2") window layer 412. The InGaAs base layer 410 of the subcell C can include, for example, in some embodiments approximately 1.5% In. Other compositions may be used as well. The base layer 410 is preferably formed over the BSF layer 409 after the BSF layer is deposited over the DBR layers 408a through 408z.

The window layer 412 is preferably deposited on the emitter layer 411 of the subcell C. The window layer 412 in the subcell C also helps reduce the recombination loss and improves passivation of the cell surface of the underlying junctions. Before depositing the layers of the subcell B, heavily doped n-type InGaP and p-type AIGaAs (or other suitable compositions) tunneling junction layers 413, 414 may be deposited over the subcell C.

The middle subcell B preferably includes a highly doped p-type aluminum gallium arsenide ("AIGaAs") back surface field ("BSF") layer 415, a p-type AlInGaAs base layer 416, preferably a highly doped n-type indium gallium phosphide ("InGaP2") or AlInGaAs layer 417 and preferably a highly doped n-type indium gallium aluminum phosphide ("AIGaAIP") window layer 418. The InGaP emitter layer 417 of the subcell B can include, for example, approximately 50% In. Other compositions may be used as well.

Before depositing the layers of the top or "upper" cell A, heavily doped n-type InGaP and p-type AIGaAs tunneling junction layers 419, 420 may preferably be deposited over the subcell B.

In the illustrated example, the top (fourth) subcell A preferably includes a highly doped p-type indium aluminum phosphide ("InAlP") BSF layer 421, preferably a p-type InGaAlP base layer 422, preferably a highly doped n-type InGaAlP emitter layer 423 and preferably a highly doped n-type InAIP2 window layer 424. The base layer 422 of the top subcell A is deposited over the BSF layer 421 after the BSF layer 421 is formed over the tunneling junction layers 419, 420 of the subcell B. The window layer 424 is deposited over the emitter layer 423 of the top subcell A after the emitter layer 423 is formed over the base layer 422.

A cap or contact layer 425 may preferably be deposited and patterned into separate contact regions over the window layer 424 of the top subcell A. The cap or contact layer 425 serves as an electrical contact from the top subcell A to metal grid layer (not shown). The doped cap or contact layer 425 can be a semiconductor layer such as, for example, a GaAs or InGaAs layer.

After the cap or contact layer 425 is deposited, the grid lines are preferably formed via evaporation and lithographically patterned and deposited over the cap or contact layer 425.

FIG. 3B is a cross-sectional view of a third embodiment of a four junction solar cell 201 after several stages of fabrication including the growth of certain semiconductor layers on the growth substrate up to the contact layer, according to the present disclosure.

The third embodiment depicted in FIG. 3B is similar to that of the second embodiment depicted in FIG. 3A except that the metamorphic buffer layer 406 is disposed beneath the tunnel diodes 403/404.

In some embodiments, at least the base of at least one of the second, third or fourth solar subcells preferably has a graded doping, i.e., the level of doping varies from one surface to the other throughout the thickness of the base layer. In some embodiments, the gradation in doping is preferably exponential. In some embodiments, the gradation in doping is preferably incremental and monotonic.

In some embodiments, the emitter of at least one of the second, third or fourth solar subcells also preferably has a graded doping, i.e., the level of doping varies from one surface to the other throughout the thickness of the emitter layer. In some embodiments, the gradation in doping is preferably linear or monotonically decreasing.

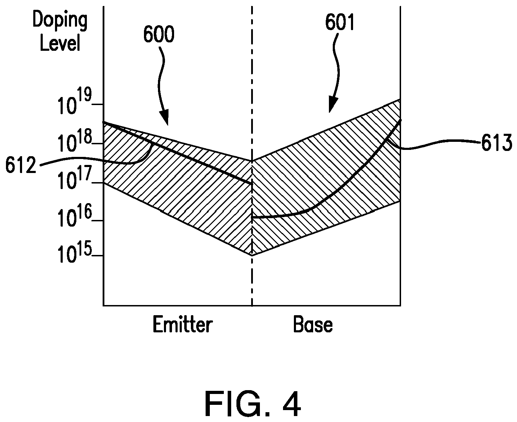

As a specific example, the doping profile of the emitter and base layers may be illustrated in FIG. 4, which depicts the amount of doping in the emitter region and the base region of a subcell. N-type dopants preferably include silicon, selenium, sulfur, germanium or tin. P-type dopants preferably include silicon, zinc, chromium, or germanium.

In the example of FIG. 4, in some embodiments, one or more of the subcells preferably have a base region 601 having a gradation in doping that increases from a value in the range of 1 × 10¹⁵ to 1 × 10¹⁸ free carriers per cubic centimeter adjacent the p-n junction to a value in the range of 1 × 10¹⁶ to 4 × 10¹⁸ free carriers per cubic centimeter adjacent to the adjoining layer at the rear of the base, and an emitter region 600 preferably having a gradation in doping that decreases from a value in the range of approximately 5 × 10¹⁸ to 1 × 10¹⁷ free carriers per cubic centimeter in the region immediately adjacent the adjoining layer to a value in the range of 5 × 10¹⁵ to 1 × 10¹⁸ free carriers per cubic centimeter in the region adjacent to the p-n junction.

The heavy lines 612 and 613 shown in FIG. 4 illustrates one embodiment of the base doping having an exponential gradation, and the emitter doping being linear.

Thus, in one embodiment, the doping level throughout the thickness of the base layer may be exponentially graded from approximately 1 × 10¹⁶ free carriers per cubic centimeter to 1 × 10¹⁸ free carriers per cubic centimeter, as represented by the curve 613 depicted in the Figure.

Similarly, in one embodiment, the doping level throughout the thickness of the emitter layer may decline linearly from approximately 5 x 10¹⁸ free carriers per cubic centimeter to 5 x 10¹⁷ free carriers per cubic centimeter, as represented by the curve 612 depicted in the Figure.

The absolute value of the collection field generated by an exponential doping gradient exp [-x/λ] is given by the constant electric field of magnitude E = kT/q(1/λ))(exp[-xb/λ]), where k is the Boltzmann constant, T is the absolute temperature in degrees Kelvin, q is the absolute value of electronic charge, and A is a parameter characteristic of the doping decay.

The efficacy of an embodiment of the doping arrangement of the present disclosure has been demonstrated in a test solar cell which incorporated an exponential doping profile in the three micron thick base layer in a subcell of one embodiment of the disclosure.

The exponential doping profile taught by one embodiment of the present disclosure produces a constant field in the doped region. In the particular multijunction solar cell materials and structure of the present disclosure, the bottom subcell has the smallest short circuit current among all the subcells. Since in a multijunction solar cell, the individual subcells are stacked and form a series electrical circuit, the total current flow in the entire solar cell is therefore limited by the smallest current produced in any of the subcells. Thus, by increasing the short circuit current in the bottom cell, the current more closely approximates that of the higher subcells, and the overall efficiency of the solar cell is increased as well. In a multijunction solar cell, the implementation of the present doping arrangement would thereby increase efficiency. In addition to an increase in efficiency, the collection field created by the exponential doping profile will enhance the radiation hardness of the solar cell, which is important for spacecraft applications.

Although the exponentially doped profile is the doping design which has been implemented and verified, other doping profiles may give rise to a linear varying collection field which may offer yet other advantages. For example, another doping profile may produce a linear field in the doped region which would be advantageous for both minority carrier collection and for radiation hardness at the end-of-life (EOL) of the solar cell. Such other doping profiles in one or more base layers are within the scope of the present disclosure.

The doping profile depicted herein are merely illustrative, and other more complex profiles may be utilized as would be apparent to those skilled in the art without departing from the scope of the present invention.

A low earth orbit (LEO) satellite will typically experience radiation equivalent to 1 × 10¹² e/cm² (written as E¹²) to 5 × 10¹⁴ e/cm² over a five year lifetime. A geosynchronous earth orbit (GEO) satellite will typically experience radiation in the range of 5 x 10¹⁴ e/cm² to 1 x 10 e/cm² over a fifteen year lifetime.

The wide range of electron and proton energies present in the space environment necessitates a method of describing the effects of various types of radiation in terms of a radiation environment which can be produced under laboratory conditions. The methods for estimating solar cell degradation in space are based on the techniques described by Brown et al. [Brown, W. L., J. D. Gabbe, and W. Rosenzweig, Results of the Telstar Radiation Experiments, Bell System Technical J., 42, 1505, 1963] and Tada [Tada, H. Y., J.R. Carter, Jr., B.E. Anspaugh, and R. G. Downing, Solar Cell Radiation Handbook, Third Edition, JPL Publication 82-69, 1982]. In summary, the omnidirectional space radiation is converted to a damage equivalent unidirectional fluence at a normalized energy and in terms of a specific radiation particle. This equivalent fluence will produce the same damage as that produced by omnidirectional space radiation considered when the relative damage coefficient (RDC) is properly defined to allow the conversion. The relative damage coefficients (RDCs) of a particular solar cell structure are measured a priori under many energy and fluence levels in addition to different cover glass thickness values. When the equivalent fluence is determined for a given space environment, the parameter degradation can be evaluated in the laboratory by irradiating the solar cell with the calculated fluence level of unidirectional normally incident flux. The equivalent fluence is normally expressed in terms of 1 MeV electrons or 10 MeV protons.

The software package Spenvis (www.spenvis.oma.be) is used to calculate the specific electron and proton fluence that a solar cell is exposed to during a specific satellite mission as defined by the duration, altitude, azimuth, etc. Spenvis employs the EQFLUX program, developed by the Jet Propulsion Laboratory (JPL) to calculate 1 MeV and 10 MeV damage equivalent electron and proton fluences, respectively, for exposure to the fluences predicted by the trapped radiation and solar proton models for specified mission environment duration. The conversion to damage equivalent fluences is based on the relative damage coefficients determined for multijunction cells [Marvin, D.C., Assessment of Multijunction Solar Cell Performance in Radiation Environments, Aerospace Report No. TOR-2000 (1210)-1,2000]. A widely accepted total mission equivalent fluence for a geosynchronous satellite mission of 15 year duration is 1MeV 1×10¹⁵ electrons/cm^{2.}.

The exemplary solar cell described herein may require the use of aluminum in the semiconductor composition of each of the top two subcells. Aluminum incorporation is widely known in the III-V compound semiconductor industry to degrade BOL subcell performance due to deep level donor defects, higher doping compensation, shorter minority carrier lifetimes, and lower cell voltage and an increased BOL E_{g}/q - V_{oc} metric. In short, increased BOL E_{g}/q - V_{oc} may be the most problematic shortcoming of aluminum containing subcells; the other limitations can be mitigated by modifying the doping schedule or thinning base thicknesses.

The present disclosure, like related U.S. Patent Application Serial No. 14/828,206, provides a multijunction solar cell that follows a design rule that one should incorporate as many high band gap subcells as possible to achieve the goal to increase the efficiency preferably at either room temperature (28° C) or high temperature (i.e., 50° to 70° C) EOL. For example, high band gap subcells may retain a greater percentage of cell voltage as temperature increases, thereby offering lower power loss as temperature increases. As a result, both HT-BOL and HT-EOL performance of the exemplary multijunction solar cell, according to the present disclosure, may be expected to be greater than traditional cells.

In view of different satellite and space vehicle requirements in terms of operating environmental temperature, radiation exposure, and operational life, a range of subcell designs using the design principles of the present disclosure may be provided satisfying specific defined customer and mission requirements, and several illustrative embodiments are set forth hereunder, along with the computation of their efficiency at the end-of-life for comparison purposes. As described in greater detail below, solar cell performance after radiation exposure is experimentally measured using 1 MeV electron fluence per square centimeter (abbreviated in the text that follows as e/cm²), so that a comparison can be made between the current commercial devices and embodiments of solar cells discussed in the present disclosure.

As a baseline comparison, the cell efficiency (%) measured at room temperature (RT) 28° C and high temperature (HT) 70° C, at beginning of life (BOL) and end of life (EOL), for a standard three junction commercial solar cell (the ZTJ of SolAero Technologies Corp., of Albuquerque, New Mexico), is as follows:

| Condition | Efficiency | |
|---|---|---|
| BOL 28° C | 29.1% | |
| BOL 70° C | 26.4% | |
| EOL 70° C | 23.4% | after 5E14 e/cm² radiation |
| EOL 70°C | 22.0% | after 1E15 e/cm² radiation |

The J_{sc} of the upper two subcells at EOL under 1E15 conditions is 17.2 mA, and the ratio of the upper junction J_{sc} to the bottom subcell J_{sc} is 139%.

The simplest manner to express the different embodiments of the present disclosure and their efficiency compared to that of the standard solar cell noted above is to list the embodiments with the specification of the composition of each successive subcell and their respective band gap, and then the computed efficiency.

Thus, for a four junction solar cell configured and described in the present disclosure, four embodiments and their corresponding efficiency data at the end-of-life (EOL) is as follows:

| Embodiment 1 | Band Gap | Composition |
|---|---|---|
| Subcell A | 2.1 eV | AlInGaP |
| Subcell B | 1.73 eV | InGaP or AlInGaAs/AlInGaAs or InGaAs |
| Subcell C | 1.41 eV | (In)GaAs |
| Subcell D | 0.67 eV | Ge |

Efficiency at 70° C after 1E15 e/cm² radiation: 23.4%

| Embodiment 2 | Band Gap | Composition |
|---|---|---|
| Subcell A | 2.1 eV | AlInGaP |
| Subcell B | 1.67 eV | InGaP or AlInGaAs/AlInGaAs or InGaAs |
| Subcell C | 1.34 eV | InGaAs |
| Subcell D | 0.67 eV | Ge |

Efficiency at 70° C after 1E15 e/cm² radiation: 23.8%

| Embodiment 3 | Band Gap | Composition |
|---|---|---|
| Subcell A | 2.1 eV | AlInGaP |
| Subcell B | 1.63 eV | InGaP or AlInGaAs/AlInGaAs or InGaAs |
| Subcell C | 1.30 eV | (In)GaAs |
| Subcell D | 0.67 eV | Ge |

Efficiency at 70° C after 1E15 e/cm² radiation: 24.2%

| Embodiment 4 | Band Gap | Composition |
|---|---|---|
| Subcell A | 2.02 eV | AlInGaP |
| Subcell B | 1.58 eV | InGaP or AlGaAs/AlInGaAs or InGaAs |
| Subcell C | 1.25 eV | (In)GaAs |
| Subcell D | 0.67 eV | Ge |

Efficiency at 70° C after 1E15 e/cm² radiation: 25.2%

For a five junction solar cell configured in the present disclosure, some embodiments and corresponding efficiency data at the end-of-life (EOL) computed at 28° C is as follows:

| Embodiment 5 | Band Gap | Composition |
|---|---|---|
| Subcell A | 1.98 eV | AlInGaP |
| Subcell B | 1.78 eV | InGaP or AlInGaAs |
| Subcell C | 1.48 eV | AlInGaAs |
| Subcell D | 1.2 eV | InGaAs |
| Subcell E | 0.67 eV | Ge |

Efficiency: 27.9%

| Embodiment 6 | Band Gap | Composition |
|---|---|---|
| Subcell A | 1.95 eV | AlInGaP |
| Subcell B | 1.69 eV | InGaP or AlInGaAs |
| Subcell C | 1.38 eV | AlInGaAs |
| Subcell D | 1.10 eV | InGaAs |
| Subcell E | 0.67 eV | Ge |

Efficiency: 28.4%

The multijunction solar cell of examples of the present disclosure have a higher cell efficiency than the standard commercial solar cell (ZTJ) at BOL at 70° C. However, the solar cell in some embodiments described in the present disclosure exhibits substantially improved cell efficiency (%) over the standard commercial solar cell (ZTJ) at 1 MeV electron equivalent fluence of 5 x 10¹⁴ e/cm², and dramatically improved cell efficiency (%) over the standard commercial solar cell (ZTJ) at 1 MeV electron equivalent fluence of 1 x 10¹⁵ e/cm².

The wide range of electron and proton energies present in the space environment necessitates a method of describing the effects of various types of radiation in terms of a radiation environment which can be produced under laboratory conditions. The methods for estimating solar cell degradation in space are based on the techniques described by Brown et al. [Brown, W. L., J. D. Gabbe, and W. Rosenzweig, Results of the Telstar Radiation Experiments, Bell System Technical J., 42, 1505, 1963] and Tada [Tada, H. Y., J.R. Carter, Jr., B.E. Anspaugh, and R. G. Downing, Solar Cell Radiation Handbook, Third Edition, JPL Publication 82-69, 1982]. In summary, the omnidirectional space radiation is converted to a damage equivalent unidirectional fluence at a normalized energy and in terms of a specific radiation particle. This equivalent fluence will produce the same damage as that produced by omnidirectional space radiation considered when the relative damage coefficient (RDC) is properly defined to allow the conversion. The relative damage coefficients (RDCs) of a particular solar cell structure are measured a priori under many energy and fluence levels in addition to different coverglass thickness values. When the equivalent fluence is determined for a given space environment, the parameter degradation can be evaluated in the laboratory by irradiating the solar cell with the calculated fluence level of unidirectional normally incident flux. The equivalent fluence is normally expressed in terms of 1 MeV electrons or 10 MeV protons.

It will be understood that each of the elements described above, or two or more together, also may find a useful application in other types of structures or constructions differing from the types of structures or constructions described above.

Without further analysis, from the forgoing others can, by applying current knowledge, readily adapt the present for various applications. Such adaptions should and are intended to be comprehended within the meaning and range of equivalence of the following claims.

## Claims

1. A multijunction solar cell comprising:
a growth substrate;
a first solar subcell disposed over or in the growth substrate;
a tunnel diode disposed over the first solar subcell;
a graded interlayer directly disposed over the tunnel diode;
a sequence of layers of semiconductor material disposed over the graded interlayer comprising one or more middle solar subcells including a second solar subcell disposed over and lattice mismatched with respect to the growth substrate;
wherein the graded interlayer has a band gap equal to or greater than that of the second subcell and is compositionally graded to lattice match the growth substrate on one side and the second subcell on the other side;
and being composed of any of the As, P, N, Sb based III-V compound semiconductors subject to the constraints of having the in-plane lattice parameter in each of the sublayers of the graded interlayer throughout its thickness being greater than or equal to the lattice constant of the growth substrate; and
an upper subcell disposed over the middle solar subcells of a semiconductor compound including at least aluminum, indium, and phosphorus and a band gap in the range of 1.95 eV to 2.20 eV; wherein either the upper solar subcell, or the middle solar subcell directly below the upper solar subcell, or both, has an aluminum content in excess of 17.5% by mole fraction, but less than 25%.

2. A multijunction solar cell as defined in claim 1, wherein the solar cell is a triple junction solar cell.

3. A multijunction solar cell as defined in claim 1, wherein the solar cell is a four junction solar cell, wherein the middle solar subcells include the second solar subcell and a third solar subcell, and wherein the upper solar subcell is a fourth solar subcell.

4. A multijunction solar cell as defined in caim 3, wherein the average band gap of all four solar subcells is greater than 1.35 eV.

5. A multijunction solar cell as defined in claim 3 or 4, wherein the upper solar subcell has a band gap in the range of approximately 1.9 eV to 2.05 eV, the third solar subcell has a band gap in the range of approximately 1.41 eV to 1.73 eV; and the second solar subcell has a band gap in the range of approximately 1.04 eV to 1.35 eV.

6. A multijuncion solar cell as defined in claim 1, wherein the solar cell is a five junction solar cell, wherein the middle solar subcells include the second solar subcell, a third solar subcell, and a fourth solar subcell, and wherein the upper solar subcell is a fifth solar subcell.

7. A multijunction solar cell, as defined in any of claims 3 - 6, wherein the fourth or upper solar subcell has an aluminum content in excess of 17.5% by mole fraction.

8. A multijunction solar cell as defined in any of claims 3 - 7, wherein the solar subcell directly below the upper solar subcell has an aluminum content in excess of 20.0% by mole fraction.

9. A multijunction solar cell as defined in any of claims 3 - 8, wherein the second solar subcell has a band gap in the range of 1.0 eV to 1.41 eV; and the third solar subcell has a band gap in the range of approximately 1.35 eV to 1.73 eV, and greater than the second solar subcell, and wherein the third and fourth solar subcells are lattice matched to the second solar subcell.

10. A multijunction solar cell as defined in any of claims 3 - 9, wherein:
the upper subcell is composed of a semiconductor compound including at least aluminum, indium and phosphorus, or the compound indium gallium aluminum phosphide:
the middle solar subcell directly below the upper solar subcell is composed of a semiconductor compound including at least indium, gallium, arsenic, and phosphorus, or the compound (aluminum) indium gallium arsenide;
the first solar subcell is composed of germanium; and
the graded interlayer is composed of N step-graded (InₓGa₁₋ₓ)_{y}Al_{1-y}As sublayers, with 0 < x < 1, 0 < y ≤ 1, where N is an integer and the value of N is 1 ≤ N < 10, wherein each successive sublayer has an incrementally greater lattice constant than the sublayer below it and grown in such a manner that each sublayer is fully relaxed.

11. A multijunction solar cell as defined in any of the preceding claims, further comprising:
a distributed Bragg reflector (DBR) structure disposed between one of the solar subcells and another of the solar subcells and is composed of a plurality of alternating layers of lattice mismatched materials with discontinuities in their respective indices of refraction and arranged so that light can enter and pass through the one solar subcell and at least a first portion of which light having a first spectral width wavelength range including the band gap of the one solar subcell can be reflected back into the one solar subcell by the DBR structure, and a second portion of which light in a second spectral width wavelength range corresponding to longer wavelengths than the first spectral width wavelength range can be transmitted through the DBR structure to the solar subcell disposed beneath the DBR structure, and
wherein the DBR structure includes a first DBR sublayer composed of a plurality of n-type or p-type Alₓ(In)Ga₁₋ₓAs layers, and a second DBR sublayer disposed over the first DBR sublayer and composed of a plurality of n type or p type Al_{y}(In)Ga_{1-y}As layers, where 0 < x <1, 0 < y < 1, and y is greater than x and the designation (In) represents an optional amount of indium in the compound so that the DBR layers are lattice matched to the one solar subcell.

12. A multifunction solar cell as defined in any of the preceding claims, wherein the graded interlayer is composed of InGaAs with the indium content in the range of 0 to 25% per mole and a thickness in the range of 100 nm to 500 nm, and a band gap in the range of 1.15 eV to 1.41 eV.

13. A multijunction solar cell as defined in any of the preceding claims, wherein one or more of the solar subcells have a base region having a gradation in doping that increases exponentially from a value in the range of 1 x 10¹⁵ to 1 x 10¹⁸ free carriers per cubic centimeter adjacent the p-n junction to a value in the range of 1 × 10¹⁶ to 4 × 10¹⁸ free carriers per cubic centimeter adjacent to the adjoining layer at the rear of the base, and an emitter region having a gradation in doping that decreases from a value in the range of approximately 5 × 10¹⁸ to 1 × 10¹⁷ free carriers per cubic centimeter in the region immediately adjacent the adjoining layer to a value in the range of 5 × 10¹⁵ to 1 × 10¹⁸ free carriers per cubic centimeter in the region adjacent to the p-n junction.

14. A multijunction solar cell as defined in claim 12, wherein the doped portion of one or more of the solar subcells may be preceded by an undoped intrinsic portion including quantum wells.

15. A method of manufacturing a multijunction solar cell for use in a space vehicle comprising:
providing a germanium growth substrate;
forming a first solar subcell over or in the growth substrate;
growing a graded interlayer over the growth substrate, followed by a sequence of layers of semiconductor material using a deposition process comprising one or more middle solar subcells including:
a second solar subcell disposed over and lattice mismatched with respect to the growth substrate and having a band gap in the range of 1.0 eV to 1.41 eV;
an upper solar subcell disposed over the middle solar subcells, and wherein either the upper solar subcell, or the middle solar subcell directly below the upper solar subcell, or both, has an aluminum content in excess of 17.5% by mole fraction, but less than 25%;
wherein the graded interlayer is compositionally graded to lattice match the growth substrate on one side and the second solar subcell on the other side, and is composed of the As, P, N, Sb based III-V compound semiconductors subject to the constraints of having the in-plane lattice parameter throughout its thickness being greater than or equal to that of the growth substrate.
